# EUROPEAN PATENT SPECIFICATION

(11) **EP 1 113 495 B1**
(45) Date of publication and mention of the grant of the patent: **21.03.2007**
(21) Application number: 00311681.1
(22) Date of filing: 22.12.2000
(51) Int. Cl.: H01L 23/367

(54) **Surface mounted power transistor with heat sink**
Oberflächenmontierter Leistungstransistor mit Kühlkörper
Transistor de puissance monté en surface avec dissipateur thermique

(30) Priority: 30.12.1999 US 173873
(43) Date of publication of application: 04.07.2001
(73) Proprietor: TEXAS INSTRUMENTS INCORPORATED, Dallas, Texas 75251 (US)
(72) Inventor: Russell, Ashdown G, Lincolnshire IL 60069 (US)
(74) Representative: Potter, Julian Mark

(56) References cited:
- EP-A- 0 926 733
- US-A- 4 961 125
- US-A- 5 047 837
- PATENT ABSTRACTS OF JAPAN vol. 1998, no. 09, 31 July 1998 (1998-07-31) -& JP 10 093270 A (NEC CORP), 10 April 1998 (1998-04-10)

## Description

The present invention relates generally to a method and apparatus for mounting a heat sink on a heat producing electrical circuit component.

Heat producing components such as field effect transistors often require heat sinks to carry away the thermal energy produced by the component. To increase the heat dissipation of the heat sink by positioning the heat sink in an air flow, typical mounting arrangements for these heat producing components include providing a finned heat sink that is elevated off a mounting surface or circuit board to which the combined heat sink/component is mounted, and the heat producing component itself is typically mounted on the elevated surface of the heat sink instead of directly on the mounting surface. For field effect power transistors, the transistor may instead be mounted in a vertical orientation on a circuit board with the heat sink mounted to one side of the transistor, thereby positioning the heat sink in an air flow. In another arrangement, the field effect transistor is mounted horizontally on the circuit board or mounting surface and a heat sink is mounted on the opposite surface of the field effect transistor to position the heat sink in the air flow or the heat sink is mounted on an opposite surface of the circuit board from the field effect transistor.

Each of these methods for mounting a heat sink to a heat producing component requires a separate mounting step for the mounting of the heat sink from the step mounting the component, each requires a separate affixing location for the heat sink and the component, and each results in a relatively high profile structure.

JP 10/093270 discloses a heat-dissipating structure for a surface mounting element. The element is soldered into a recessed part of the structure.

US 5047837 discloses a semiconductor package structure in which a semiconductor chip pad is extended to the exterior of the package and connected to a heat transfer cap.

US 4961125 discloses an apparatus and method for attaching an electronic device package to a circuit board. The electronic device package is secured to a heat sink by a clip.

EP 0926733 disclosed card assembly of a power device in a plastic package with an external heat sink soldered to an internal heat sink.

Viewed from a first aspect, the present invention provides a heat sink for a surface mountable heat producing component which affixes the surface mountable component to the circuit board and the heat sink to the surface mountable component in a single step. In another aspect, it provides a low profile heat sink. A further aspect provides a heat sink having a small footprint occupying a minimum area on a mounting surface. Viewed from a yet further aspect, the invention minimises space interference between the heat sink and other components to be mounted on the mounting surface. Still another aspect of the invention is to provide a surface mountable heat sink.

A heat sink assembly in accordance with the present invention is defined in claim 1. A method of mounting a heat sink with a heat generating component in accordance with the invention is defined in claim 13.

An embodiment of the invention provides the advantage of eliminating the need for a separate mounting step of a heat sink while permitting low profile surface mounting of the heat producing component, all without requiring mounting holes through the circuit board. An embodiment of the present invention may also provide a low profile heat sink, enabling more compact circuits to be produced with tighter clearances between adjacent circuit boards, for example. An embodiment of the present invention may also reduce or eliminate the speed for multiple affixing locations by requiring application of solder only to a single surface for mounting of the component to a circuit board and for mounting of the heat sink.

These and other aspect and advantages of the invention may be embodied by a heat sink having a mounting plate which extends between a mounting surface of the heat producing component and the circuit board on which the component is to be mounted. The mounting plate of the heat sink is provided with solder conducting openings which pass through the plate. A solder pad is formed on the circuit board or on the heat producing component and the mounting pad is positioned against the solder pad so that during a solder reflow process, the liquid solder flows through the solder conducting openings to solder the mounting plate of the heat sink to the circuit board and to solder the heat producing component to the mounting plate of the heat sink.

The mounting plate of the heat sink is thermally connected to a heat dissipating element. The heat dissipating element may be a traditional finned heat sink structure. However, various preferred embodiments of the invention provide heat dissipating elements which present a low profile. In particular, the heat dissipating element in each of the preferred embodiments extends substantially parallel to the circuit board on which the component is mounted, and so provide a low profile for the component and heat sink combination from the surface of the circuit board. Miniaturization of the circuit is thereby facilitated.

For purposes of embodiments of the present invention, the term heat producing component relates to any component to be cooled, and references to circuit boards of mounting locations refer to any location or surface at which the component is to be mounted.

Embodiments of the invention will now be described, by way of example only, with reference to the accompanying drawings, in which:
Figure 1 is an exploded perspective view of a power transistor for surface mounting on a circuit board between which is provided the mounting plate of the present heat sink;
Figure 2 is a perspective view of a first embodiment of the present heat sink according to the principles of the present invention;
Figure 3 is a perspective view of a second embodiment of the present heat sink;
Figure 4 is a perspective view of a third embodiment of the heat sink of the invention; and
Figure 5 is a perspective view of a fourth embodiment.

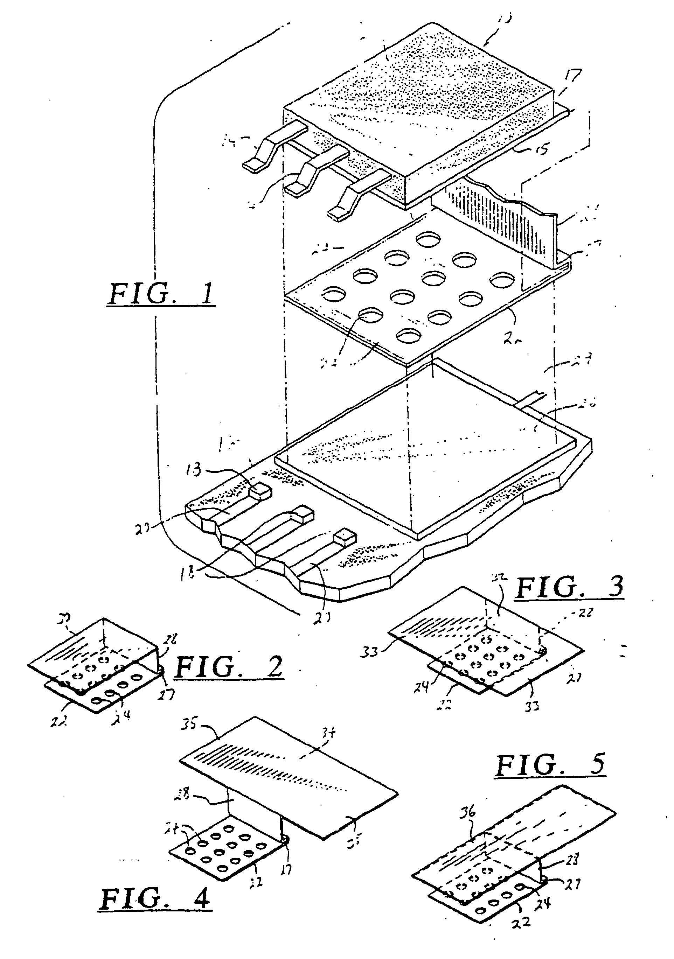

In Figure 1, a power transistor 10 has a housing 12 and three surface mount leads 14 extending from the housing 12. The power transistor 10 is a field effect transistor (FET), although for purposes of the embodiments of the present invention it may be any heat producing component or component to be cooled. The power transistor 10 is to be mounted on a circuit board 16. In the illustration, the power transistor 10 is to be surface mounted onto the circuit board 16 by soldering of the transistor leads 14 onto solder pads 18 on the circuit board. The solder pads 18 are connected by surface leads or lands 20 to other components (not shown) on the circuit board 16 which together with the power transistor form an electrical circuit. The power transistor 10 is to be surface mounted, so that it is mounted flat, lying substantially parallel to the circuit board 16. Not only does this facilitate the surface mounting of the transistor leads 14, but it also provides a lower clearance for the component above the circuit board 16 to facilitate miniaturization of the electronic device in which the component is used. The power transistor 10 has a metal plate 15 on its mounting surface, and the metal plate 15 has a tab 17 extending from the housing along one edge thereof. In the illustration, the tab 17 extends from the edge opposite the leads 14, although it may extend from another edge.

In an embodiment of the present invention, a mounting plate 22 is positioned between the circuit board 16 and the power transistor 10. In the illustrated embodiment, the mounting plate 2 has the same profile shape as the mounting surface of the power transistor housing 12. Specifically, the mounting plate 22 has the same shape at the metal plate 15. The mounting plate 22 has a plurality of openings 24 that, in the illustrated example, are in a regular arrangement in the mounting plate.

A vertical portion or extension 28 extends perpendicularly from the mounting plate 22. The extension 28 has a channel 27 that is formed to accept the tab 17. The tab 17 of the power transistor 10 is inserted into the channel 27 and the channel 27 is crimped closed to hold the transistor 10 in position until completion of the mounting process. This crimping of the channel 27 on the tab 17 is referred to as a pre-mounting of the power transistor to the mounting plate 22.

The extension 28 extends to a heat dissipation element (see Figure 2, for example) which may be any configuration capable of dissipating the heat generated by the power transistor 10 during its operation. For example, the heat dissipation element may be a traditional finned structure. Other shapes are possible as well. The mounting plate 22 and the extension 28 along with the heat dissipation element are of a thermally conductive material, such as copper. It is preferred that the mounting pad and heat dissipation element be shaped so that they may be formed by extrusion.

On the surface of the circuit board 16 is a solder pad 26 for soldering the mounting pad 22 and power transistor 10 to the circuit board 16. Although the solder pad 26 may be generally of the same surface area and dimensions of the mounting plate 22, it is preferably slightly larger in area than the mounting pad 22 so as to increase the quantity of solder in the solder pad 26. The solder pad 26 may instead or in addition be thicker than is required to solder only the power transistor 10 in place.

A ground connection for the power transistor 10 is provided by a ground lead 29 that is on the surface of the circuit board 16 and which extends under the solder pad 26.

During assembly, the circuit board 16 is prepared by forming the circuit leads 20 and the ground lead 29 at their respective locations for connection into the electrical circuit. The solder pads 18 and the large solder pad 26 is also formed on the circuit board 16. Solder is printed onto the circuit board 16 according to the known solder application techniques. For example, a mask having openings for the solder pads 18 and 26 is positioned over the circuit board 16. A squeegee or a doctor blade is used to spread the solder material evenly and with a uniformly flat surface. The mask has an opening larger than the mounting plate 22 to form the solder pad 26 in a slightly larger area than the mounting plate 22. Alternately, by shaping the mask to be thicker in the region of the solder pad 26, a thicker application of solder at the solder pad 26 is accomplished as a way to increase the quantity of solder in the solder pad 26.

After the circuit board structures have been formed, the mounting plate 22 with the power transistor 10 crimped in the channel 27 to retain the two in position is placed atop the solder pad 26. The transistor leads 14 are aligned with and positioned atop the circuit solder pads 16. Following the positioning step, a solder reflow process is undertaken by heating the components and the circuit board, such as in an oven. The solder pad 26 liquifies and some of the solder from the pad flows through the openings 24 to the mounting surface at the metal plate 15 at the underside of the power transistor 10 and some of the solder remains between the circuit board 16 and the mounting plate 22, so that when cooled the solder affixes the power transistor 10 to the mounting plate 22 which is in turn affixed to the circuit board 16 by the solder. Since some of the solder of the solder pad is sucked up through the openings 24, the solder pad which is slightly larger than the mounting plate provides the extra quantity of solder needed.

The transistor leads 14 are also soldered to the circuit solder pads 18 during this solder reflow process. Any other solder connections for other components on the circuit board are formed simultaneously during this reflow step. Thus, the mounting of the power transistor 10 to the circuit board 16 for electrical operation simultaneously mounts the mounting plate 22 of the heat dissipation sink in place.

In the preferred embodiment, the mounting plate 22 and its associated heat dissipation element are of copper and the solder conducting openings 24 are generally of 0.040 inches in diameter. This size opening has been found to readily conduct the liquified solder through the mounting plate 22 to the transistor surface during the reflow process. Other sizes of solder conducting openings 24 are contemplated as needed for solder or adhesive materials of different viscosities. An adhesive, such as a thermally activated adhesive material may be provided in place of the solder pad 26. The solder conducting openings 24 are arranged in a grid arrangement. The openings may be in some other arrangement, including staggered rows, for example. The openings 24 are circular bores but may be slots, channels, or other shapes as desired.

Only a single reflow operation need be performed to mount and bond all components together in a single step. The resulting assembly is of a low profile and a small size, and assembly is rapid since separate fastening steps are eliminated. The size of the mounting plate 22 and the solder pad 26 there underneath can be configured to conform to any transistor or other heat generating component requiring cooling.

In Figure 2 is shown an illustration of a heat conducting heat element 30 which extends from the vertical extension 28 to a position generally parallel to and overlying the mounting plate 22. The heat dissipation element 30 is spaced from and lying over the power transistor 10 when in place so that the resulting heat sink assembly occupies no greater surface area of the circuit board than the power transistor itself and only slightly more height from the circuit board 16 than the transistor alone. The heat dissipating element 30 is a plate formed by bending a sheet of thermally conductive material at two parallel lines into a generally "U" shape, one leg of the "U" being the mounting plate 22 with openings 24. The heat dissipating element 30 is approximately the same size as the mounting plate 22 as seen in Figure 2, although other sizes of the heat conducting element 30 are also contemplated. To obtain sufficient heat dissipation surface for most applications, the heat dissipating element is at least as large as the transistor 10.

An alternative embodiment of the heat sink is shown in Figure 3 wherein a heat dissipation element 32 is provided over and generally parallel to the mounting pad 22 but extending to a greater length in a transverse direction than the embodiment of Figure 2. The heat sink of Figure 3 provides a greater thermal dissipation surface than the embodiment of Figure 2. However, the element 32 has lateral extensions 33 that may interfere with some circuit arrangements.

Should the circuit components on the circuit board 16 require a heat dissipation element arranged differently than shown in Figure 3, an alternative arrangement of the heat dissipation element 34 is shown in Figure 4 wherein the heat dissipation element 34 is bent in a direction opposite that shown in Figure 3 so that from a side view the device has a Z-shape. The element 34 has lateral extensions 35 at each end. The heat dissipation element 34 and extensions 35 extend over a region of the circuit board 16 at a position adjacent one side of the transistor or other element 10. Some circuit board arrangements may better utilize the embodiment of Figure 4 rather than Figure 3, or vice versa. Both are formed from the same blank by bending in a different direction.

In the embodiments of Figures 3 and 4, the extended portions 33 and 35 of the heat dissipation elements 32 and 34 are in a transverse direction relative to the vertical extension 28 from the power transistor. Should the components on the circuit board onto which the device is mounted lack clearance for such transverse extensions, a sink heat as shown in Figure 5 may be provided. In the embodiment of Figure 5, an extended heat dissipation element 36 extends both over the mounting pad 22 and in an opposite direction relative to the vertical extension 28. The heat dissipation element 36 may be formed from a flat blank by bending portions back on themselves to achieve the shape of Figure 5. The heat sink of Figure 5 is formed alternatively by extrusion. It may also be formed by stamping and folding the sheet material back on itself.

The heat sink shown in embodiments of the present invention is of a simple construction which may be formed from a sheet of thermally conductive material such as copper. The embodiments of Figures 2, 3 and 4 are all formed by merely cutting, drilling and bending the sheet without assembly of any further parts. In Figure 5, the heat dissipation surface 36 would require an assembly step or an extrusion to form this embodiment. It is contemplated that many other arrangements of heat dissipation elements such as multiple finned surface or the like may be provided to carry the heat from the heat generating component 10, through the mounting pad 22, through the vertical extension 28 and to the heat dissipating element 30-36. Heat is, of course, dissipated from the pad 22 and extension 28 as well as from the component 10 itself. Greater heat dissipation may be achieved by heat dissipating elements with a greater height from the circuit board. Use of these is acceptable if clearance is not an issue. However, for minimum height requirements, the illustrated embodiments provide heat dissipation with only slightly greater heights from the circuit board surface than the surface mount transistor alone.

The heat dissipating element of the illustrated embodiments may be used as an attachment surface for more conventional heat sink structures where space permits and where heat generation requires it. Such conventional heat sink structures include finned structures. As an alternative, the traditional heat sink structure may be formed integrally with the top portion of the present heat sink. The result is a traditional heat sink with the mounting plate according to Figure 1.

Thus, there is shown and described a heat sink for a surface mounted component and method which provides for assembly of the heat sink with the component while mounting the component on the circuit board all in one step. The resulting assembly is compact to provide for a reduced size for the overall apparatus into which it is incorporated. The assembled circuit board, heat sink and component assembly is affixed together as strong or even more strongly than mounting of the component directly on the circuit board. All of these advantages are achieved using a single reflow process for the assembly.

Although other modifications and changes may be suggested by those skilled in the art, it is the intention of the inventors to embody within the patent warranted hereon all changes and modifications as reasonably and properly come within the scope of their contribution to the art.

The scope of the present disclosure includes any novel feature or combination of features disclosed therein either explicitly or implicitly or any generalisation thereof irrespective of whether or not it relates to the claimed invention or mitigates any or all of the problems addressed by the present invention.

## Claims

1. A heat sink assembly for a surface mounted heat generating component, comprising:
a mounting plate (22) comprising a plurality of adhesive flow openings (24) therethrough, said mounting plate having a first major surface configured to be positioned on a mounting pad of a circuit board, and a second major surface opposite said first major surface and configured for receiving a heat generating component (10) thereon;
an extension member (28) extending from the mounting plate and generally perpendicular to said major surfaces of said mounting plate; and
a heat dissipation element (30, 32, 34, 36) thermally connected to said extension member and being spaced from said mounting plate, wherein said heat dissipation element, said extension member and said mounting plate are thermally conductive **characterised in that** the extension member comprises a channel (27) along an edge for receiving a tab (17) extending from a heat generating component (10).

2. The heat sink assembly of claim 1, further comprising:
a circuit board (16) having a mounting pad (26) provided with an adhesive material in a mounting region, wherein said first major surface of said mounting plate is positioned on said mounting pad (26) of said circuit board, and said heat dissipation element is spaced from said circuit board (16); and
a heat generating component mounted on said second major surface of said mounting plate by adhesive material.

3. The heat sink of Claim 2, wherein said adhesive material is electrical solder.

4. The heat sink of Claim 2, wherein said adhesive material is thermal adhesive.

5. The heat sink assembly of Claim 4, wherein said heat dissipation element includes a portion generally parallel to said mounting plate (22) and spaced therefrom.

6. The heat sink assembly of Claim 5, wherein said portion overlies said mounting plate (22).

7. The heat sink assembly of Claim 5 or Claim 6, wherein said portion includes lateral extensions.

8. The heat sink assembly of any one of Claimes 5 to 7, wherein said mounting plate (22) and said extension (28) and said portion from a U-shape.

9. The heat sink assembly of any one of Claims 5 to 7, wherein said mounting plate (22) and said extension (28) and said portion form a Z-shape.

10. The heat sink assembly of claim 1, wherein the heat dissipation element is disposed in a position to permit air flow between said heat dissipation element and said heat generating component.

11. The heat sink assembly of claim 1, wherein the mounting plate has a shape and dimensions of said major surfaces substantially corresponding to a footprint of the heat generating component.

12. The heat sink assembly of any preceding claim, wherein the heat generating component is a power transistor.

13. A method for mounting a heat sink with a heat generating component (10), comprising the steps of:
applying a pad of adhesive material (26) to a mounting region of a circuit board (16);
positioning a first major surface of a mounting plate (22) of the heat sink on said pad of adhesive material (26) at said mounting region of said circuit board;
positioning the heat generating component on a second major surface of the mounting plate (22) the second major surface being opposite the first major surface, the positioning including locating a tab (17) of the heat generating component into a channel (27) of an extension member (23) generally perpendicular to said major surfaces of said mounting plate, the extension member being configured for having a heat dissipation element (30, 32, 34, 36) thermally connected thereto; and
liquifying the adhesive material to flow through openings (24) in said mounting plate to adhere said circuit and said mounting plate and said heat generating component to one another.

14. The method of Claim 13, further comprising the step of fastening said heat generating component on said first major surface of said mounting plate prior to said step of positioning said second major surface of said mounting plate on said pad of adhesive material.

15. The method of Claim 14, wherein said step of fastening is by crimping said channel on said mounting plate onto said tab on said heat generating component.

## Patentansprüche

1. Kühlkörperbaugruppe für ein oberflächenmontiertes wärmeerzeugendes Bauteil, umfassend:
eine Befestigungsplatte (22), die mehrere sie durchragende Haftmittelströmungsöffnungen (24) umfaßt, wobei die Befestigungsplatte eine erste Hauptoberfläche, die dafür ausgebildet ist, auf einer Befestigungskontaktfläche einer Leiterplatte positioniert zu werden, und eine der ersten Hauptoberfläche entgegengesetzte zweite Hauptoberfläche hat, die dafür ausgebildet ist, ein wärmeerzeugendes Bauteil (10) auf sich aufzunehmen;
ein Fortsatzelement (28), das sich von der Befestigungsplatte und im wesentlichen senkrecht zu den Hauptoberflächen der Befestigungsplatte erstreckt; und
ein Wärmeableitungselement (30, 32, 34, 36), das thermisch mit dem Fortsatzelement verbunden und von der Befestigungsplatte beabstandet ist, wobei das Wärmeableitungselement, das Fortsatzelement und die Befestigungsplatte thermisch leitend sind, **dadurch gekennzeichnet, daß** das Fortsatzelement entlang einer Kante einen Kanal (27) zur Aufnahme einer Zunge (17) umfaßt, die sich von einem wärmeerzeugenden Bauteil (10) erstreckt.

2. Kühlkörperbaugruppe nach Anspruch 1, weiterhin umfassend:
eine Leiterplatte (16) mit einer Befestigungskontaktfläche (26), die in einem Befestigungsbereich mit einem Haftmaterial versehen ist, wobei die erste Hauptoberfläche der Befestigungsplatte auf der Befestigungskontaktfläche (26) der Leiterplatte positioniert und wobei das Wärmeableitungselement von der Leiterplatte (16) beabstandet ist; und
ein wärmeerzeugendes Bauteil, das mit Haftmaterial an der zweiten Hauptoberfläche der Befestigungsplatte befestigt ist.

3. Kühlkörper nach Anspruch 2, bei dem das Haftmaterial elektrisches Lot ist.

4. Kühlkörper nach Anspruch 2, bei dem das Haftmaterial thermisches Haftmittel ist.

5. Kühlkörperbaugruppe nach Anspruch 4, bei der das Wärmeableitungselement einen Abschnitt aufweist, der im wesentlichen parallel zur Befestigungsplatte (22) und von dieser beabstandet ist.

6. Kühlkörperbaugruppe nach Anspruch 5, bei der der Abschnitt über der Befestigungsplatte (22) liegt.

7. Kühlkörperbaugruppe nach Anspruch 5 oder Anspruch 6, bei der der Abschnitt seitliche Fortsätze aufweist.

8. Kühlkörperbaugruppe nach einem der Ansprüche 5 bis 7, bei der die Befestigungsplatte (22), der Fortsatz (28) und der Abschnitt eine U-Form bilden.

9. Kühlkörperbaugruppe nach einem der Ansprüche 5 bis 7, bei der die Befestigungsplatte (22), der Fortsatz (28) und der Abschnitt eine Z-Form bilden.

10. Kühlkörperbaugruppe nach Anspruch 1, bei der das Wärmeableitungselement in einer Position angeordnet ist, die einen Luftstrom zwischen dem Wärmeableitungselement und dem wärmeerzeugenden Bauteil gestattet.

11. Kühlkörperbaugruppe nach Anspruch 1, bei der die Befestigungsplatte eine Form und Abmessungen der Hauptoberflächen hat, die im wesentlichen einer Anschlußfläche des wärmeerzeugenden Bauteils entsprechen.

12. Kühlkörperbaugruppe nach einem der vorhergehenden Ansprüche, bei der das wärmeerzeugende Bauteil ein Leistungstransistor ist.

13. Verfahren zur Befestigung eines Kühlkörpers an einem wärmeerzeugenden Bauteil (10), umfassend folgende Schritte:
Aufbringen einer Kontaktfläche aus Haftmaterial (26) auf einen Befestigungsbereich einer Leiterplatte (16);
Positionieren einer ersten Hauptoberfläche einer Befestigungsplatte (22) des Kühlkörpers auf der Kontaktfläche aus Haftmaterial (26) im Befestigungsbereich der Leiterplatte;
Positionieren des wärmeerzeugenden Bauteils auf einer zweiten Hauptoberfläche der Befestigungsplatte (22), wobei die zweite Hauptoberfläche der ersten Hauptoberfläche entgegengesetzt ist, wobei das Positionieren beinhaltet, daß eine Zunge (17) des wärmeerzeugenden Bauteils in einem Kanal (27) eines Fortsatzes (23) aufgenommen wird, der im wesentlichen senkrecht zu den Hauptoberflächen der Befestigungsplatte ist, wobei der Fortsatz dafür ausgebildet ist, daß ein Wärmeableitungselement (30, 32, 34, 36) thermisch mit ihm verbunden wird; und
Verflüssigen des Haftmaterials, so daß es durch Öffnungen (24) in der Befestigungsplatte fließt, um den Schaltkreis, die Befestigungsplatte und das wärmeerzeugende Bauteil miteinander zu verkleben.

14. Verfahren nach Anspruch 13, das weiterhin den Schritt des Fixierens des wärmeerzeugenden Bauteils an der ersten Hauptoberfläche der Befestigungsplatte umfaßt, vor dem Schritt des Positionierens der zweiten Hauptoberfläche der Befestigungsplatte auf der Kontaktfläche aus Haftmaterial.

15. Verfahren nach Anspruch 14, bei dem der Schritt des Fixierens durch Crimpen des Kanals an der Befestigungsplatte auf die Zunge am wärmeerzeugenden Bauteil erfolgt.

## Revendications

1. Ensemble dissipateur thermique pour un composant générateur de chaleur monté en surface, comprenant :
une plaque de montage (22) comprenant une pluralité d'ouvertures d'écoulement d'adhésif (24) à travers celle-ci, ladite plaque de montage comportant une première surface principale configurée pour être positionnée sur une plage de montage d'une carte de circuit imprimé, et une seconde surface principale opposée à ladite première surface principale et configurée pour recevoir un composant générateur de chaleur (10) sur celle-ci ;
un élément d'extension (28) s'étendant depuis la plaque de montage et globalement perpendiculaire auxdites surfaces principales de ladite plaque de montage ; et
un élément de dissipation thermique (30, 32, 34, 36) relié par voie thermique audit élément d'extension et espacé de ladite plaque de montage, ledit élément de dissipation thermique, ledit élément d'extension et ladite plaque de montage étant thermiquement conducteurs, **caractérisé en ce que** l'élément d'extension comprend un canal (27) le long d'un bord destiné à recevoir une languette (17) s'étendant depuis un composant de génération de chaleur (10).

2. Ensemble dissipateur thermique selon la revendication 1, comprenant en outre :
une carte de circuit imprimé (16) possédant une plage de montage (26) dotée d'un matériau adhésif dans une région de montage, ladite première surface principale de ladite plaque de montage étant positionnée sur ladite pastille de montage (26) de ladite carte de circuit imprimé, et ledit élément de dissipation thermique étant espacé de ladite carte de circuit imprimé (16) ; et
un composant générateur de chaleur monté sur ladite seconde surface principale de ladite plaque de montage par un matériau adhésif.

3. Dissipateur thermique selon la revendication 2, dans lequel ledit matériau adhésif est un métal d'apport de brasage électrique.

4. Dissipateur thermique selon la revendication 2, dans lequel ledit matériau adhésif est un adhésif thermique.

5. Ensemble dissipateur thermique selon la revendication 4, dans lequel ledit élément de dissipation thermique comprend une partie globalement parallèle à ladite plaque de montage (22) et espacée de celle-ci.

6. Ensemble dissipateur thermique selon la revendication 5, dans lequel ladite partie recouvre ladite plaque de montage (22).

7. Ensemble dissipateur thermique selon la revendication 5 ou 6, dans lequel ladite partie comprend des extensions latérales.

8. Ensemble dissipateur thermique selon l'une quelconque des revendications 5 à 7, dans lequel ladite plaque de montage (22) et ladite extension (28) et ladite partie forment une forme de U.

9. Ensemble dissipateur thermique selon l'une quelconque des revendications 5 à 7, dans lequel ladite plaque de montage (22) et ladite extension (28) et ladite partie forment une forme de Z.

10. Ensemble dissipateur thermique selon la revendication 1, dans lequel l'élément de dissipation thermique est disposé dans une position pour permettre un écoulement d'air entre ledit élément de dissipation thermique et ledit composant générateur de chaleur.

11. Ensemble dissipateur thermique selon la revendication 1, dans lequel la plaque de montage présente une forme et des dimensions desdites surfaces principales correspondant sensiblement à une empreinte du composant générateur de chaleur.

12. Ensemble dissipateur thermique selon l'une quelconque des revendications précédentes, dans lequel le composant générateur de chaleur est un transistor de puissance.

13. Procédé de montage d'un dissipateur thermique avec un composant générateur de chaleur (10), comprenant les étapes consistant à :
appliquer une pastille de matériau adhésif (26) à une région de montage d'une carte de circuit imprimé (16) ;
positionner une première surface principale d'une plaque de montage (22) du dissipateur thermique sur ladite pastille de matériau adhésif (26) au niveau de ladite région de montage de ladite carte de circuit imprimé ;
positionner le composant de génération de chaleur sur une seconde surface principale de la plaque de montage (22), la seconde surface principale étant opposée à la première surface principale, le positionnement comprenant l'insertion d'une languette (17) du composant de génération de chaleur dans un canal (27) d'un élément d'extension (23) globalement perpendiculaire auxdites surfaces principales de ladite plaque de montage, l'élément d'extension étant configuré pour avoir un élément de dissipation thermique (30, 32, 34, 36) relié thermiquement à celui-ci ; et
liquéfier le matériau adhésif pour qu'il s'écoule à travers les ouvertures (24) dans ladite plaque de montage afin de faire adhérer ledit circuit et ladite plaque de montage et ledit composant générateur de chaleur les uns aux autres.

14. Procédé selon la revendication 13, comprenant en outre l'étape consistant à fixer ledit composant générateur de chaleur sur ladite première surface principale de ladite plaque de montage avant ladite étape de positionnement de ladite seconde surface principale de ladite plaque de montage sur ladite pastille de matériau adhésif.

15. Procédé selon la revendication 14, dans lequel ladite étape de fixation se fait en pinçant ledit canal sur ladite plaque de montage sur ladite languette sur ledit composant générateur de chaleur.
